# EUROPEAN PATENT SPECIFICATION

(11) **EP 2 020 392 B1**
(45) Date of publication and mention of the grant of the patent: **23.10.2013**
(21) Application number: 08013867.0
(22) Date of filing: 01.08.2008
(51) Int. Cl.: B65H 20/02, B65H 39/16

(54) **Apparatus for manufacturing thin-film laminated member**
Vorrichtung zur Herstellung eines dünnfilmbeschichteten Elements
Appareil pour la fabrication d'un élément stratifié à film mince

(30) Priority: 03.08.2007 JP 2007202694; 03.08.2007 JP 2007202695; 03.08.2007 JP 2007202696
(43) Date of publication of application: 04.02.2009
(73) Proprietor: Fuji Electric Co., Ltd., Kawasaki-shi Kanagawa (JP)
(72) Inventor: Yokoyama, Shoji, Kawasaki-shi 210-9530 (JP); Ouchi, Takashi, Kawasaki-shi 210-9530 (JP); Naruse, Mitsuhiro, Kawasaki-shi 210-9530 (JP); Kamoshida, Takashi, Kawasaki-shi 210-9530 (JP)
(74) Representative: MERH-IP Matias Erny Reichl Hoffmann

(56) References cited:
- WO-A-96/26879
- JP-A- 10 158 848
- JP-A- 11 334 949
- JP-A- 2001 110 729
- US-A- 4 774 796
- US-A- 5 595 334

## Description

### BACKGROUND OF THE INVENTION

### 1. Field of the Invention

The present invention relates to an apparatus for manufacturing a thin-film laminated member such as a thin-film photoelectric conversion element by forming a plurality of thin-films on a band-shaped flexible substrate.

### 2. Description of the Related Art

In general, a high-rigidity substrate is used as a substrate for a thin-film laminated member such as a semiconductor thin-film. However, a flexible substrate formed of resin or the like is also used as a substrate for a photoelectric conversion element used, for example, for a solar battery or the like because of the convenience such as being light-weight and easy-to-handle or for cost reduction by mass-production.

As an apparatus for manufacturing a thin-film laminated member using such the flexible substrate, a film-forming apparatus adapted to pass a band-shaped flexible substrate through a plurality of film-forming chambers arranged in succession, repeat an operation to form a film on the flexible substrate in a halted state in each film forming chamber, and then transfer the flexible substrate to a position of the next film forming chamber and laminate a plurality of thin films being different in character on the flexible substrate is developed (For example, see JP-A-2005-72408).

The closest prior art as is represented by the document JP 101 58 848.

As the film forming apparatus as described above, there are a type of holding the band-shaped flexible substrate with the direction of the width thereof oriented in the horizontal direction and forming the films while conveying the band-shaped flexible substrate in the horizontal direction (in other words, a state in which a surface of the band-shaped flexible substrate to be formed with the films is oriented in the horizontal direction) and a type of holding the band-shaped flexible substrate in such a manner that the widthwise direction thereof is oriented in the vertical direction and forming the films while conveying the band-shaped flexible substrate in the horizontal direction (in other words, a state in which the surface of the band-shaped flexible substrate to be formed with the films is oriented in the vertical direction). The latter type has such advantage that the surface of the substrate is hardly contaminated in comparison with the former type. However, when the number of film forming chambers increases, there arise such problems that the surface of the band-shaped flexible substrate gets wrinkles due to the gravitational force or elongation of the band-shaped flexible substrate, the band-shaped flexible substrate snakes in the widthwise direction, or the band-shaped flexible substrate sags.

In order to solve such the problems, there is proposed arranging an intermediate chamber between two film-forming chambers positioned in the middle of a number of film-forming chambers and providing an edge position controlling (EPC) roller which comes into contact with the surface of the substrate over the entire surface of the substrate in the widthwise direction in the intermediate chamber. In general, however, since the film-formation is carried out at a relatively high temperature, there is such a problem that when the EPC roller formed of stainless-steel is arranged between the film-forming chambers, the substrate is rapidly cooled down and hence gets wrinkles.

### SUMMARY OF THE INVENTION

In view of such problem described above, it is an object of the invention to provide an apparatus for manufacturing a thin-film laminating member which is able to prevent generation of wrinkles on the surface of the band-shaped flexible substrate, widthwise meandering of the band-shaped flexible substrate and sagging of the band-shaped flexible substrate even when the band-shaped flexible substrate is conveyed in the horizontal direction for a long distance in such a manner that the widthwise direction of the band-shaped flexible substrate is oriented in the vertical direction, so that the position of the band-shaped flexible substrate in the vertical direction may be maintained at a high degree of accuracy.

This object is achieved according to a first aspect of the invention by an apparatus as claimed in claim 1. Preferred embodiments of the invention are defined in the dependent claims a substrate conveying device for conveying the band-shaped flexible substrate in the horizontal direction in such a manner that the widthwise direction of the band-shaped flexible substrate is oriented in the vertical direction; a plurality of film forming chambers arranged in succession along the direction in which the band-shaped flexible substrate is conveyed for forming films on the surface of the band-shaped flexible substrate; and at least a pair of upper grip rollers arranged between the plurality of film forming chambers for pinching an upper edge portion of the band-shaped flexible substrate.

With the arrangement of at least a pair of the grip rollers which pinch the upper edge portion of the band-shaped flexible substrate between the plurality of film forming chambers, even when the band-shaped flexible substrate is conveyed over a long distance through the plurality of film forming chambers, generation of wrinkles on the band-shaped flexible substrate, widthwise meandering of the band-shaped flexible substrate and sagging of the band-shaped flexible substrate are prevented.

The apparatus for manufacturing a thin-film laminated member according to the invention preferably includes two or more pairs of grip rollers for pinching the upper edge portion installed in succession between the two film forming chambers positioned at the center from among the plurality of film forming chambers.

The plurality of pairs of the upper grip rollers are able to support the weight of the band-shaped flexible substrate dispersedly thereby, so that the band-shaped flexible substrate is conveyed stably.

According to a second aspect of the invention, the pairs of the upper grip rollers are installed in such a manner that the direction of rotation of the respective rollers is inclined obliquely upward with respect to the direction in which the band-shaped flexible substrate is conveyed.

In this arrangement, even when the band-shaped flexible substrate is conveyed for a long distance through the plurality of film forming chambers, a sagged portion of the band-shaped flexible substrate is pulled upward when being passed through the pairs of upper grip rollers, and hence generation of wrinkles on the band-shaped flexible substrate, widthwise meandering of the band-shaped flexible substrate and sagging of the band-shaped flexible substrate are prevented further reliably in comparison with the first aspect of the invention.

According to a third aspect of the invention, at least one pair of lower grip rollers for pinching the lower edge portion of the band-shaped flexible substrate are provided between the plurality of film forming chambers in addition to the first or the second aspect of the invention.

In this arrangement, even when the band-shaped flexible substrate is conveyed for a long distance through the plurality of film forming chambers, the band-shaped flexible substrate is supported in the vertical direction by the pairs of upper grip rollers and the pairs of lower grip rollers when the band-shaped flexible substrate which is subjected to be sagged is conveyed in a state of being pinched by the pairs of upper grip rollers and the pairs of lower grip rollers, and hence generation of wrinkles on the band-shaped flexible substrate, widthwise meandering of the band-shaped flexible substrate and sagging of the band-shaped flexible substrate are prevented further reliably in comparison with the first and the second aspect of the invention.

According to a fourth aspect of the invention, the pairs of lower grip rollers are installed in such a manner that the direction of rotation of the respective rollers is inclined obliquely downward with respect to the direction in which the band-shaped flexible substrate is conveyed in addition to the forth aspect of the invention.

In this arrangement, even when the band-shaped flexible substrate is conveyed for a long distance through the plurality of film forming chambers, the band-shaped flexible substrate is supported by the pair of upper grip rollers and the pair of lower grip rollers in the vertical direction when the band-shaped flexible substrate which is subjected to be sagged is conveyed in a state of being pinched by the pairs of upper grip rollers and the pairs of lower grip rollers. Furthermore, at least one of the pairs of upper grip rollers and the pairs of lower grip rollers are installed in such a manner that the direction of rotation of the respective rollers is inclined obliquely upward for the pair of upper grip rollers or obliquely downward for the pair of lower grip roller with respect to the direction in which the band-shaped flexible substrate is conveyed. Therefore, when the band-shaped flexible substrate is conveyed in the direction to be conveyed, the band-shaped flexible substrate pinched between the pair of upper grip rollers and the pair of lower grip rollers may be pulled in the vertical direction.

Therefore, generation of wrinkles on the band-shaped flexible substrate, widthwise meandering of the band-shaped flexible substrate, and sagging of the band-shaped flexible substrate are prevented further reliably in comparison with the third aspect of the invention.

As described thus far, according to the present invention, even when the band-shaped flexible substrate is conveyed for a long distance in the horizontal direction in such a manner that the widthwise direction of the band-shaped flexible substrate is oriented in the vertical direction, generation of wrinkles on the surface of the band-shaped flexible substrate, widthwise meandering of the band-shaped flexible substrate and sagging of the band-shaped flexible substrate are prevented, so that an apparatus for manufacturing a thin-film laminated member in which the position of the band-shaped flexible substrate in the vertical direction is maintained with a high degree of accuracy is provided.

### BRIEF DESCRIPTION OF THE DRAWINGS

- Fig. 1: is a plan view schematically showing an embodiment of an apparatus for manufacturing a thin-film laminated member according to the invention;
- Fig. 2: is a front view viewed from the line II-II in Fig. 1;
- Fig. 3A: is a schematic enlarged plan cross section of a film forming chamber shown in Fig. 1;
- Fig. 3B: is a front view viewed from the line B-B in Fig. 3A;
- Fig. 4: is a schematic perspective view showing an example of grip rollers and the attached device thereof;
- Fig. 5: is a front view of the grip rollers in Fig. 4 and the attached device thereof;
- Fig. 6: is a plan view schematically showing an experimental device used in a test in Example 2;
- Fig. 7: is a plan view schematically showing another experimental device used in the test in Example 2;
- Fig. 8: is a graph showing a result of a test in which a Kapton film is used in the experimental device in Fig. 6;
- Fig. 9: is a graph showing a result of a test in which the Kapton film is used in the experimental device in Fig. 7;
- Fig. 10: is a graph showing a result of a test in which an amorphous silicon film is used in the experimental device in Fig. 6; and
- Fig. 11: is a graph showing a result of a test in which the amorphous silicon film is used in the experimental device in Fig. 7.

### DESCRIPTION OF THE PREFERRED EMBODIMENTS

Referring now to the attached drawings, an apparatus for manufacturing a thin-film laminated member according to the invention will be described in further detail. Although the detailed configuration of the thin-film laminated member is not specifically described here, the invention may be applied to manufacture of the thin-film laminated member such as the photoelectric conversion element for a solar battery or a semiconductor thin film such as an organic EL or the like.

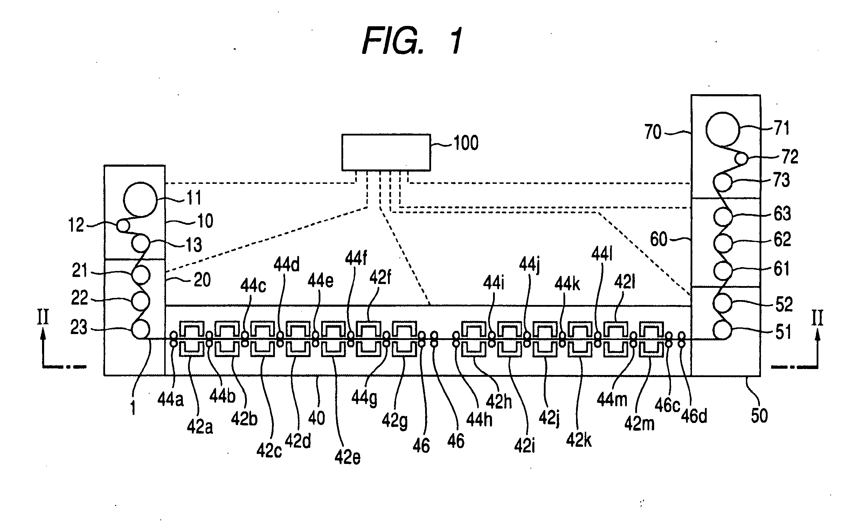

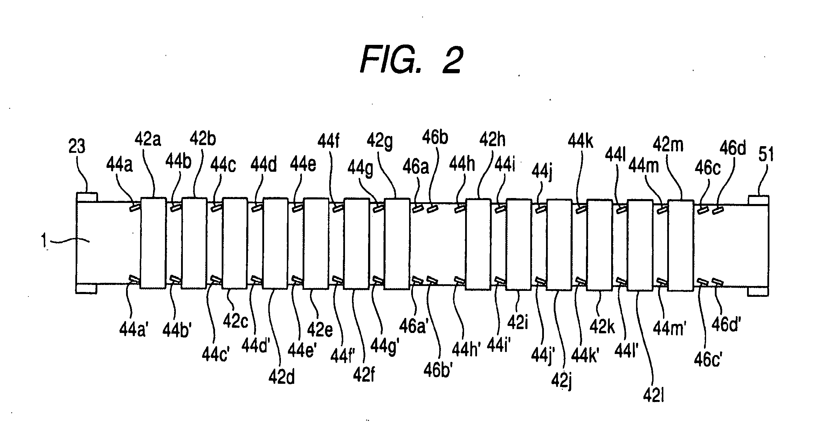

Fig. 1 is a plan view showing an embodiment of an apparatus for manufacturing a thin-film laminated member according to the invention. Fig. 2 is a front view viewed from the line II-II in Fig. 1. The drawing is not a drawing to scale.

As shown in Fig. 1 and Fig. 2, the apparatus for manufacturing a thin-film laminated member mainly includes an unwinding unit 10 for feeding a band-shaped flexible substrate 1, an unwinding drive 20 for conveying the band-shaped flexible substrate 1 from the unwinding unit 10 to a film forming section 40, the film forming section 40 for laminating a plurality of thin films on the band-shaped flexible substrate 1, a side edge position controller 50 for controlling the edge position of the band-shaped flexible substrate 1, a winding side drive 60 for conveying the band-shaped flexible substrate 1 from the film forming section 40 to a winding unit 70, and the winding unit 70 for winding the band-shaped flexible substrate 1 formed with the thin-film laminated member. The band-shaped flexible substrate 1 is conveyed in the horizontal direction in such a manner that the widthwise direction of the band-shaped flexible substrate is oriented in the vertical direction.

The unwinding unit 10 includes an unwinding core 11 which rotatably supports a whole roll of the band-shaped flexible substrate 1 and feeds the band-shaped flexible substrate 1, a tensile strength detection roller 13 for detecting the tensile strength of the band-shaped flexible substrate 1 fed from the unwinding core 11, and an auxiliary roller 12. The unwinding core 11, the auxiliary roller 12 and the tensile strength detection roller 13 are installed with the axial directions thereof oriented in the vertical direction, respectively. The respective rollers described below are installed with the axial direction thereof oriented in the vertical direction.

The unwinding drive 20 is provided with an unwinding-side film drive roller 21 which rotates for conveying the band-shaped flexible substrate 1 from the unwinding unit 10 to the film forming section 40, a tensile strength detection roller 22 for detecting the tensile strength of the band-shaped flexible substrate 1 when being driven, and an auxiliary roller 23 for changing the direction of travel of the band-shaped flexible substrate 1 by 90 degrees and feeding the same to the film forming section 40.

The film forming section 40 includes a plurality of film forming chambers 42a to 42m arranged in a linear array for laminating thin films on the surface of the band-shaped flexible substrate 1 in sequence. Pairs of grip rollers 44a to 44m for pinching the band-shaped flexible substrate 1 are provided on the upstream side of respective substrate entrances of the respective film forming chambers 42a to 42m. As shown in Fig. 2, the pairs of grip rollers 44a to 44m, 44a' to 44m' are arranged along an upper edge portion and a lower edge portion of the band-shaped flexible substrate 1 in terms of the vertical direction, respectively. The pairs of upper grip rollers 44a to 44m are installed in such a manner that the direction of rotation of the respective rollers is inclined obliquely upward with respect to the direction in which the band-shaped flexible substrate 1 is conveyed as described later in detail. The pairs of lower grip rollers 44a' to 44m' are installed in such a manner that the direction of rotation of the respective rollers is inclined obliquely downward with respect to the direction in which the band-shaped flexible substrate 1 is conveyed.

Figs. 1 and 2 shows thirteen film forming chambers 42a to 42m. However, the number of film forming chambers is not limited to thirteen, but may be any number as long as there are a plurality of film forming chambers. A plurality of pairs of grip rollers 46a and 46b are in succession provided at a position substantially at the center of the plurality of film forming chambers, that is, between a seventh film forming chamber 42g and a eighth film forming chamber 42h. There are also provided a plurality of pairs of grip rollers 46c and 46d in succession also outside the last film forming chamber, that is, at a substrate exit of a thirteenth film forming chamber 42m. The pairs of lower grip rollers 46a' to 46d' for supporting the lower end of the band-shaped flexible substrate 1 in terms of the vertical direction are arranged below the pairs of upper grip rollers 46a to 46d.

The side edge position controller 50 in Fig. 1 includes a meandering detection roller 51 for detecting the position of the side edge of the band-shaped flexible substrate 1 coming out from the film forming section 40 and a side edge position controlling (EPC) roller 52 for preventing the band-shaped flexible substrate 1 from meandering in the vertical direction, that is, in the widthwise direction. The meandering detection roller 51 or the meandering detection sensor may be provided in a carrier path of the band-shaped flexible substrate 1 as needed. The EPC roller 52 has a roller width larger than the width of the band-shaped flexible substrate 1. The side edge position controller 50 allows compensation of the error in vertical position (height of conveyance) of the band-shaped flexible substrate 1. The side edge position controller 50 as described above is normally provided between the unwinding drive 20 and the film forming section 40 or between the two film forming chambers 42g and 42h positioned at the center of the film forming section 40. However, in this embodiment, the grip rollers 44b to 44m are provided respectively between the adjacent film forming chambers 42a to 42m to restrain the meandering of the band-shaped flexible substrate 1 in the film forming section 40, so that provision of the side edge position controllers at positions as described above is not necessary.

The winding side drive 60 includes a winding-side film drive roller 63 which rotates for conveying the band-shaped flexible substrate 1 from the film forming section 40 to the winding unit 70, a tensile strength detection roller 62 for controlling the tensile strength of the band-shaped flexible substrate 1 at the winding side drive 60 is driven, and an auxiliary roller 61 for receiving the band-shaped flexible substrate 1 from the side edge position controller 50.

The winding unit 70 includes a winding core 71 for winding the band-shaped flexible substrate 1 formed with the thin-film laminated member into a roll, a tensile strength detection roller 73 for detecting the tensile strength of the band-shaped flexible substrate 1 when being wound, and an auxiliary roller 72.

Subsequently, the structure of the film forming chambers 42a to 42m will be described in detail using the periphery of the film forming chamber 42b as a representative. Since a plurality of thin films having different characters are laminated on the surface of the band-shaped flexible substrate 1, the structures of the respective film forming chambers are different depending on the types of the thin films to be formed. The film forming chamber for forming an amorphous silicon layer by plasma CVD will be described here. The same structure may be employed also for the case of forming other types of thin films as long as the interior of the film forming chamber is brought into a hermetical state.

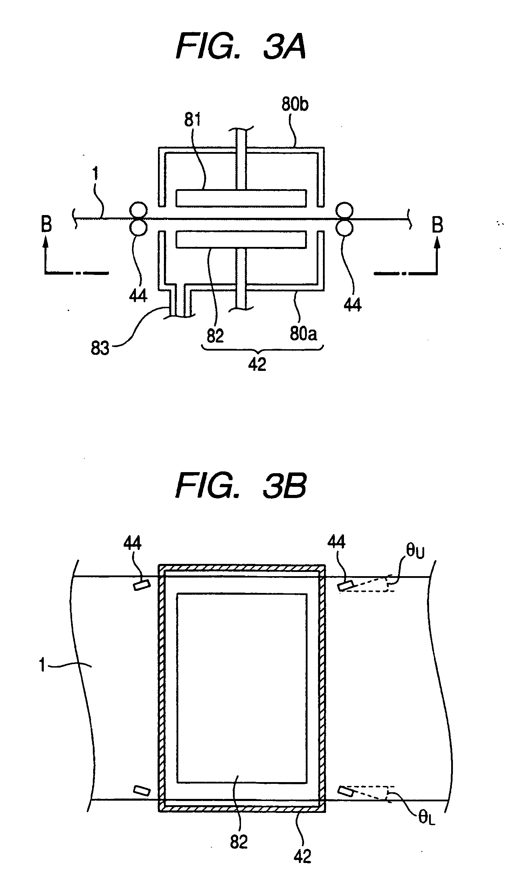

Fig. 3A is a schematic enlarged plan cross section of a periphery of the film forming chamber 42b as a representative of the film forming chambers 42a to 42m shown in Fig. 1. Fig. 3B is a front view viewed from the line B-B in Fig. 3A. As shown in Figs. 3A and 3B, walls 80a and 80b of the film forming chamber having a U-shape in cross section are arranged on both sides of the band-shaped flexible substrate 1. When forming a film, the walls 80a and 80b move until the distal ends of the walls come into tight contact with the surfaces of the band-shaped flexible substrate 1. Sealing members (not shown) for bringing the interior of a film forming chamber 42 into a hermetical state are attached to the distal ends of a wall 80.

In an inner space of the film forming chamber 42, a high-voltage electrode 81 and an earth electrode 82 having a substrate heater are installed so as to oppose each other with the intermediary of the band-shaped flexible substrate 1. The film forming chamber 42 is provided with an exhaust pipe 83 which exhausts the air from the film forming chamber and brings the same into vacuum. The film forming chamber 42 is also provided with an introduction pipe (not shown) for introducing reaction gas such as silane. The introduced reaction gas is decomposed by plasma generated between the high-voltage electrode 81 and the earth electrode 82 and allows formation of a thin film on the band-shaped flexible substrate 1.

The widthwise lengths of the high-voltage electrode 81 and the earth electrode 82 are shorter than the width of the band-shaped flexible substrate 1 so as to leave margins where the thin film is not formed on both ends of the band-shaped flexible substrate 1 as shown in Fig. 3B. Then, the pair of grip rollers 44b and 44c are arranged on the upper side of the band-shaped flexible substrate 1 and the pair of grip rollers 44b' and 44c' are arranged on the lower side thereof in such a manner that the band-shaped flexible substrate 1 is interposed between the margins. By pinching the margins where the thin film is not formed by the pairs of grip rollers 44b, 44c, 44b' and 44c', formation of wrinkles on a portion of the band-shaped flexible substrate 1 where the thin film is to be formed or damage of the formed thin film is prevented. Although the pair of upper grip rollers 44b and 44c may answer the purpose, provision of the pair of upper grip rollers 44b and 44c and the pair of lower grip rollers 44b' and 44c' is preferable.

As shown in Fig. 2, the upper pairs of grip rollers 44a to 44m and 46a to 46d are installed with the direction of rotation of the rollers inclined upward with respect to the direction in which the band-shaped flexible substrate 1 is conveyed (that is, the horizontal direction). In this manner, by forming an angle θ_{U} between the direction of rotation of the pairs of upper grip rollers 44a to 44m and 46a to 46d and the direction in which the band-shaped flexible substrate 1 is conveyed, a force to lift the band-shaped flexible substrate 1 upward is generated when the band-shaped flexible substrate 1 is conveyed in the horizontal direction, and hence the vertical position of the band-shaped flexible substrate 1 may be maintained with a high degree of accuracy. In particular, the plurality of pairs of grip rollers 46a and 46b provided in succession between the two film forming chambers located in the middle are able to support the mass of the band-shaped flexible substrate 1 and restore the height of the band-shaped flexible substrate 1 being conveyed reliably to the initial height as a reference. The plurality of grip rollers 46c and 46d provided in succession after the last film forming chamber are also able to support the mass of the band-shaped flexible substrate 1 and restore the height of the band-shaped flexible substrate 1 being conveyed reliably as in the case described above. The angle θ_{U} is preferably in a range from 0.1° to 6°. The larger the angle θ_{U} is, the larger the force to lift the band-shaped flexible substrate 1 becomes. However, when the angle θ_{U} exceeds 6° or when a static friction of the rollers is exceeded, the force to lift the band-shaped flexible substrate 1 is little improved.

As shown in Fig. 2, the pairs of lower grip rollers 44a' to 44m' and 46a' to 46d' are installed with the direction of rotation thereof inclined downward with respect to the direction in which the band-shaped flexible substrate 1 is conveyed (that is, the horizontal direction). In this manner, by forming an angle θ_{L} between the direction of rotation of the pairs of lower grip rollers 44a' to 44m' and 46a' to 46d' and the direction in which the band-shaped flexible substrate 1 is conveyed, generation of wrinkles on the surface of the band-shaped flexible substrate 1 is prevented further reliably when the band-shaped flexible substrate 1 is conveyed in the horizontal direction. The angle θ_{L} is preferably in a range from 0.1 to 6°. The angles θ_{U} and θ_{L} may be the same and may be different.

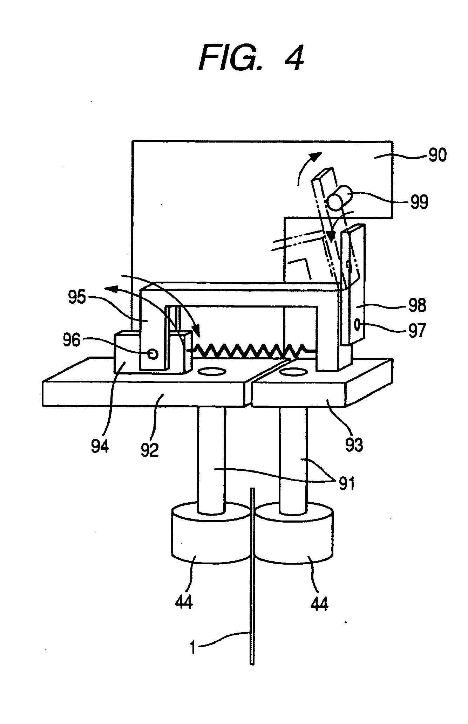

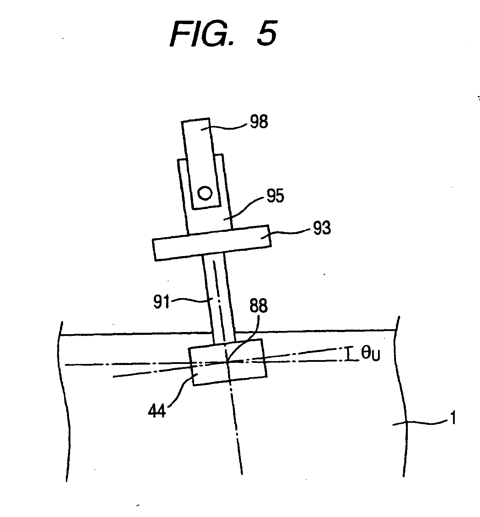

Subsequently, configurations of the pair of grip rollers 44 and an attached device thereof will be described. Fig. 4 is a schematic perspective view showing an example of the pair of upper grip rollers and the attached device thereof. Fig. 5 is a front view of the pair of grip rollers and the attached device thereof shown in Fig. 4. As shown in Fig. 4 and Fig. 5, the pair of grip rollers 44 are rotatably fixed to the lower end of roller fixing shafts 91, respectively. The upper end of one of the roller fixing shafts 91 is fixed to the lower surface of a fixed roller unit 92, and the upper end of the other roller fixing shaft 91 is fixed to the lower surface of a movable roller unit 93.

A rotation supporting member 94 is provided on the upper surface of the fixed roller unit 92, and an end of an inverted U-shaped handle 95 is provided on the upper surface of the movable roller unit 93. The other end of the handle 95 is fixed so as to be capable of rotating about the rotation supporting member 94 and the hinge 96. The pair of grip rollers 44 are adapted to pinch the band-shaped flexible substrate 1 therebetween and to move apart from each other to increase the distance therebetween by rotating the movable roller unit 93 about a hinge 96. The rotation supporting member 94 and the other end of the handle 95 are connected by an extension spring, so that the length of the extension spring is minimized when the band-shaped flexible substrate 1 is pinched between the pair of grip rollers 44.

The pressurizing force between the pair of grip rollers 44 with respect to the band-shaped flexible substrate 1 is adjustable by the strength of the extension spring.

An end of a lever 98 is attached to the other end of the handle 95 so as to be rotatable about a hinge 97. The axis of rotation of the hinge 97 is vertical to the axis of rotation of the hinge 96. The fixed roller unit 92 is fixed to the surface of a fixing plate 90, and a bar 99 is provided on the surface of the fixing plate 90 so as to project therefrom. The bar 99 is positioned on a trajectory of the other end of the lever 98 when the handle 95 is rotated about the hinge 96. In other words, the bar 99 is located at a position which hinders the rotation of the handle 95 by coming into contact with the other end of the lever 98. When the lever 98 is rotated about the hinge 97 to prevent the lever 98 from coming into abutment with the bar 99, the handle 95 is allowed to rotate freely.

The grip rollers 44 are installed with the direction of rotation of the roller inclined upward with respect to the direction in which the band-shaped flexible substrate 1 is conveyed as shown in Fig. 5. The angle θ_{U} between the direction of rotation of the roller and the direction in which the band-shaped flexible substrate 1 is conveyed may be fixed to a certain angle, or may be adapted to be changeable during film formation. When changing the angle θ_{U}, the angle is preferably adjusted about center points 88 of the axes of rotation of the grip rollers 44. By adjusting the angle θ_{U} with the center points 88 used as fulcrums, formation of the wrinkles on the band-shaped flexible substrate 1 or meandering of the band-shaped flexible substrate 1 may be prevented. In particular, it is preferable to configure the plurality of pairs of grip rollers 46a to 46d arranged in succession on the upper side to be adjustable in angle. Accordingly, the height of the band-shaped flexible substrate 1 being conveyed may be adjusted to be the initial height as a reference with a high degree of accuracy.

The configurations of the upper grip rollers 44a to 44m and the attached device thereof have been described thus far. The lower grip rollers 44a' to 44m' and the attached device thereof may have the same configurations although the upside comes down. The plurality of pairs of grip rollers 46a' to 46d' arranged in succession may also have the same configuration. The surfaces of the grip rollers44 which come into contact with the band-shaped flexible substrate 1 are preferably formed of heat-resistant rubber such as silicon rubber or fluorine-contained rubber or synthetic resin such as PTFE or polyimide. A material formed by chrome plating stainless or iron also achieves the same performance.

The device of the invention is further provided with a control device 100 which controls conveyance and halt of the band-shaped flexible substrate 1 and movement of the walls 80 of the respective film forming chambers 42. The control device 100 is able to change the angles θ_{U} and θ_{L} of the pairs of grip rollers 44a to 44m, 44a' to 44m', 46a to 46d and 46a' to 46d' according to the extent of meandering of the band-shaped flexible substrate 1 as needed. Broken lines continued to the control device 100 in Fig. 1 represent control signal lines between the control device 100 and the respective units.

The band-shaped flexible substrate 1 passing through the interiors of the plurality of film forming chambers 42a to 42m by the drives 20 and 60 on the unwinding side and the winding side, and the band-shaped flexible substrate 1 is conveyed from the unwinding core 11 to the winding core 71 horizontally. When forming the film, the unwinding-side film drive roller 21 and the winding-side film drive roller 63 stop to halt the band-shaped flexible substrate 1, and then the walls 80a and 80b of the respective film forming chambers 42a to 42m are moved until they come in tight contact with the band-shaped flexible substrate 1 to bring the interiors of the film forming chambers into a hermetical state. Then the thin film is formed on the surface of the band-shaped flexible substrate 1 in each film forming chamber.

After having formed the film, the walls 80a and 80b of the film forming chambers are restored to their original position to release the hermetical state. Again, the unwinding-side film drive roller 21 and the winding-side film drive roller 63 are rotated to convey the band-shaped flexible substrate 1 to align the positions of the next film forming chambers. Then, the interiors of the respective film forming chambers are brought into a hermetical state again and the film is formed on the halted band-shaped flexible substrate 1. By repeating the operation to convey the band-shaped flexible substrate 1 and film formation, a thin-film laminated member is formed on the surface of the band-shaped flexible substrate 1.

The band-shaped flexible substrate 1 moves a long distance form the first film forming chamber 42a to the thirteenth film forming chamber 42m. However, when the band-shaped flexible substrate 1 is supported only by the auxiliary roller 23 of the unwinding drive 20 and the meandering detection roller 51 of the side edge position controller 50 positioned on both ends of this section, the band-shaped flexible substrate 1 is sagged by the gravitational force of the elongation thereof or is meandered in the direction of width of the band-shaped flexible substrate 1. However, according to the embodiment, since the upper side edge of the band-shaped flexible substrate 1 is pinched by the upper grip rollers 44a to 44m provided before the respective entrances of the substrate of the first to thirteenth film forming chambers 42a to 42m, the sagging of the band-shaped flexible substrate 1 is prevented and meandering and formation of wrinkles is prevented even when the band-shaped flexible substrate 1 moves for a long distance from the first film forming chamber 42a to the thirteenth film forming chamber 42m.

In particular, the respective grip rollers 44a to 44m on the vertical upper side of the band-shaped flexible substrate 1 are installed with the direction of rotation of the rollers inclined upward with respect to the direction in which the band-shaped flexible substrate 1 is conveyed so as to generate a strong force to lift the band-shaped flexible substrate 1 upward. Therefore, even when the band-shaped flexible substrate 1 is conveyed for a distance of 20 m, the vertical meandering of the band-shaped flexible substrate 1 may be restrained to a range of approximately ± 2.5 mm.

The film forming device of a stepping roll system which repeats conveyance and halt of the band-shaped flexible substrate has been described thus far. However, the invention may be applied not only to the stepping roll system, but also to various types of systems as long as the device is adapted to convey the band-shaped flexible substrate for a long distance in the horizontal direction with the widthwise direction of the band-shaped flexible substrate oriented in the vertical direction.

### EXAMPLES

### Example 1: Measurement Test of Lifting Force of Band-Shaped Flexible Substrate

Using the grip rollers having the structure shown in Fig. 4 and Fig. 5, a test for measuring the force to lift the band-shaped flexible substrate 1 was conducted. The grip rollers formed of silicon rubber were used. A Kapton film was used as the band-shaped flexible substrate 1. The pressurizing force of the grip rollers with respect to the band-shaped flexible substrate was changed to three values; 4.4 N, 8.9 N and 16.3 N. The angle θ of the grip rollers in the direction of rotation was changed from 0 to 7° by the increment of 1° at each pressurizing forces. The lifting force was measured as follows. First of all, a suspending balance was provided at a position of the band-shaped flexible substrate 1 which is to be pinched by the pair of grip rollers when the band-shaped flexible substrate 1 was not being conveyed and the pair of grip rollers were not in contact with the band-shaped flexible substrate 1, and a relation between the height of the band-shaped flexible substrate 1 and the force required for lifting the band-shaped flexible substrate 1 when the band-shaped flexible substrate 1 was pulled upward were measured in advance. Then, the height of the band-shaped flexible substrate 1 when the height of the band-shaped flexible substrate 1 was stabilized was measured in a state in which the band-shaped flexible substrate 1 is being conveyed and the band-shaped flexible substrate 1 was pinched by the pair of grip rollers. Then, the height of the band-shaped flexible substrate 1 being conveyed was converted into a force required for lifting the same on the basis of the relation between the height of the band-shaped flexible substrate 1 and the force required for lifting the same which was obtained in advance.

As a result of the test, when the angle θ of the roller in the direction of rotation is 0°, the lifting force was 0 N at any pressurizing forces. However, when the pressurizing force was as high as 16.3 N, the lifting force increased significantly with the increment of the angle θ by 1°, and was increased to about 13 N at an angle θ of 6°. In contrast, when the pressurizing force was as low as 4.4 N, the lifting force was increased with the increment of the angle θ by 1°. However, even though the angle θ was increased to 6°, the increase of the pressurizing force was only to about 3 N. When the pressurizing force is 8.9 N, the lifting force was increased only to about 6 N even though the angle θ was increased to 6°. The increase of the lifting force was little between the angle θ of 6° and 7° at any pressurizing forces.

### Example 2: Test of Measurement of Meandering of Band-Shaped Flexible Substrate

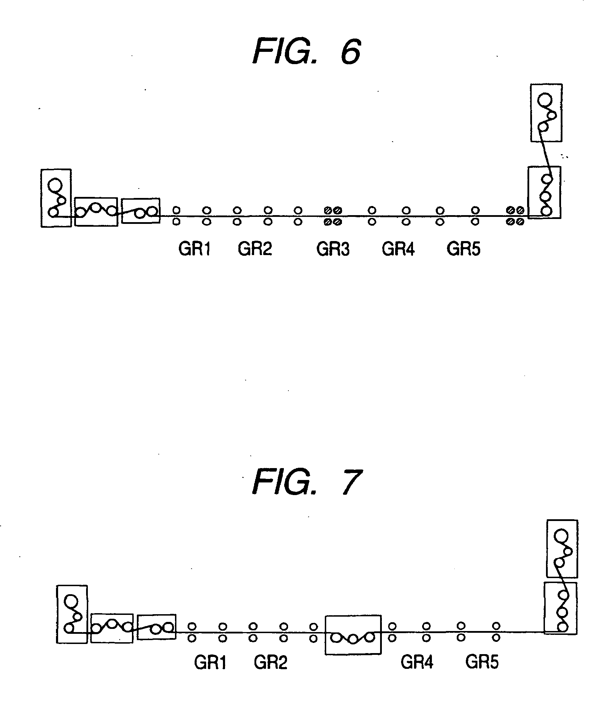

Using experimental devices shown in Fig. 6 and Fig. 7, a test for measuring the vertical meandering of the band-shaped flexible substrate 1 quantitatively was conducted. The basic configuration of the experimental device shown in Fig. 6 is the same as that of the device shown in Fig. 1 and Fig. 2 other than that the side edge position controller is provided on the unwinding side of the film forming section, and that the film forming chamber is not provided. The experimental device shown in Fig. 6 includes nine pairs of the upper and lower grip rollers (both θ_{U} and θ_{L} are 1°) and only the two pairs of upper grip rollers (θ_{U} of 1.5°) in succession at the middle position thereof and the last position respectively. The section in which these pairs of grip rollers were installed, that is, a section between the rollers with the EPC meandering sensor and the feed rollers was set to a length of 20 m. The experimental device shown in Fig. 7 had the same configuration as the experimental device in Fig. 6 other than that the above-described two pairs of upper grip rollers (θ_{U} is 1.5°) arranged in succession were not provided at the middle position and the last position, and an intermediate chamber including three EPC rollers was provided at an intermediate position.

### A: Effects of Material of Band-Shaped Flexible Substrate

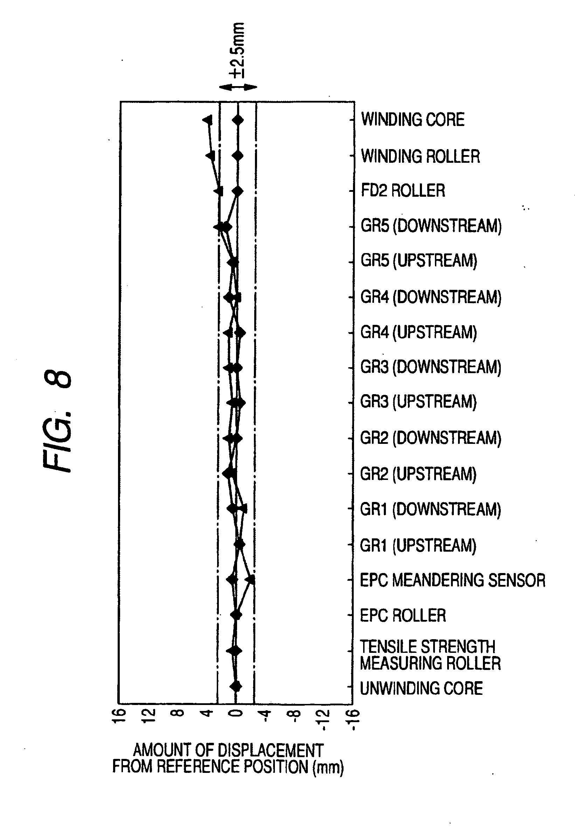

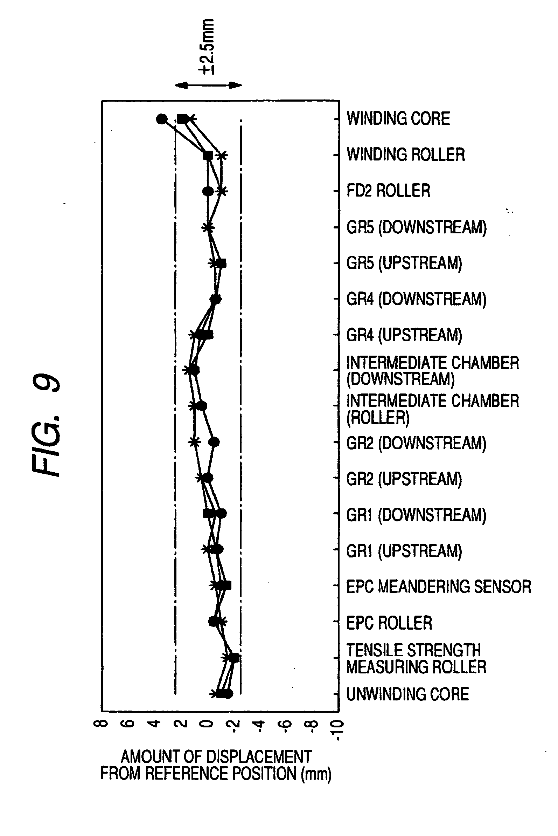

A result of a case in which the Kapton film was used as the band-shaped flexible substrate 1 in the experimental device in Fig. 6 is shown in Fig. 8. As shown in a graph in Fig. 8, the band-shaped flexible substrate 1 meandered little, and the amount of displacement of the band-shaped flexible substrate 1 from the reference position was within the ±2.5 mm. A result of a case in which the Kapton film was used in the experimental device in Fig. 7 is shown in Fig. 9. As a result of the experimental device having the intermediate chamber shown in Fig. 7 as well, the amount of displacement from the reference position was within ± 2.5 mm. In this manner, in the case of the experimental device in Fig. 6 which is not provided with the intermediate chamber, meandering of the band-shaped flexible substrate 1 was occurred little as in the case of the experimental device shown in Fig. 7 which is provided with the intermediate chamber.

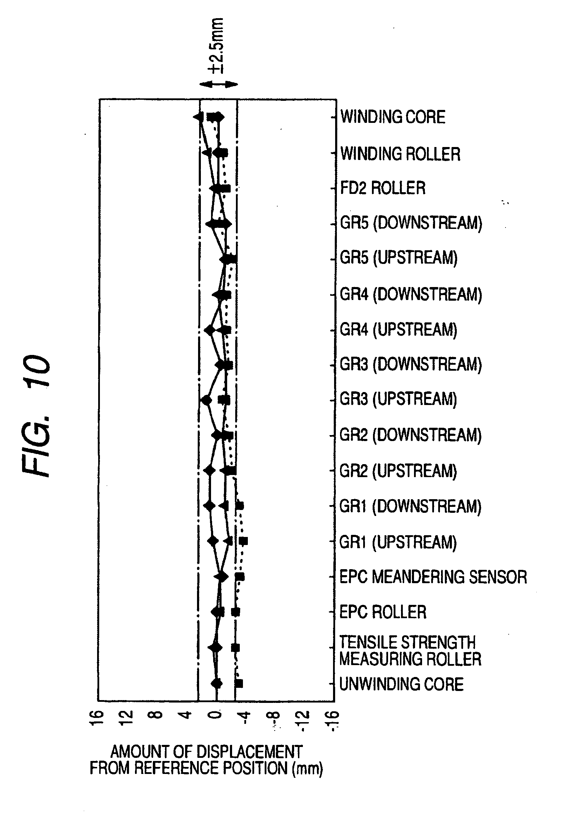

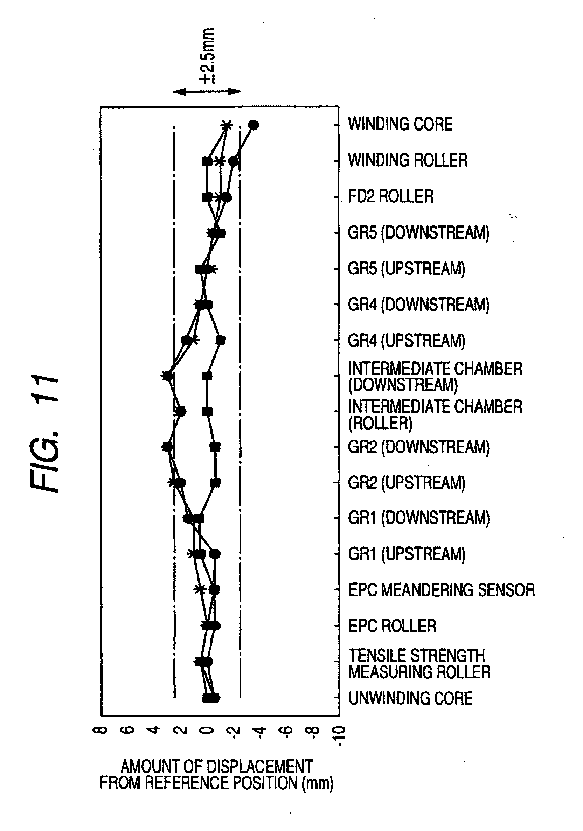

A result of a case in which an amorphous silicon film is used as the band-shaped flexible substrate 1 is shown in Fig. 10. As shown in a graph in Fig. 10, meandering occurred little in the case of the amorphous silicon film, and the amount of displacement of the band-shaped flexible substrate 1 from the reference position was within the ± 2.5 mm. A result of a case in which the amorphous silicon film is used in the experimental device in Fig. 7 is shown in Fig. 11. As a result of the experimental device provided with the intermediate chamber in Fig. 7, the amount of displacement of the band-shaped flexible substrate 1 from the reference position was approximately within the ± 2.5 mm as well. In this manner, even when the amorphous silicon film is used, in the case of the experimental device in Fig. 6 which is not provided with the intermediate chamber, meandering of the band-shaped flexible substrate 1 was occurred little as in the case of the experimental device in Fig. 7 which is provided with the intermediate chamber.

Although the pairs of grip rolls are provided between all the adjacent film forming chambers in the embodiments shown above, a configuration in which the pair of grip rolls are provided only between some of the adjacent film forming chambers as needed is also applicable.

## Claims

1. An apparatus for manufacturing a thin-film laminated member by laminating a plurality of thin films on the surface of a band-shaped flexible substrate comprising:
a substrate conveying device (10, 20, 50, 60, 70) for conveying the band-shaped flexible substrate (1) in the horizontal direction in such a manner that the widthwise direction of the band-shaped flexible substrate (1) is oriented in the vertical direction;
a plurality of film forming chambers (42a-42m) arranged in succession along the direction in which the band-shaped flexible substrate (1) is conveyed for forming films on the surface of the band-shaped flexible substrate (1); and
one or more pairs of upper grip rollers (44b-44m, 46a, 46b) arranged between the plurality of film forming chambers (42a-42m) for pinching an upper edge portion of the band-shaped flexible substrate (1).

2. The apparatus according to Claim 1, wherein the one or more pairs of upper grip rollers (44b-44m, 46a, 46b) are installed between each pair of adjacent forming chambers (42a-42m).

3. The apparatus according to Claim 1 or 2, wherein two or more pairs of upper grip rollers (44b-44m, 46a, 46b) are installed between the pair of adjacent forming chambers (42a-42m) positioned closest to the center of the arrangement of film forming chambers.

4. The apparatus according to any one of the preceding Claims, wherein the one or more pairs of upper grip rollers (44b-44m, 46a, 46b) are installed in such a manner that the direction of rotation of the respective rollers is inclined obliquely upward with respect to the direction in which the band-shaped flexible substrate (1) is conveyed.

5. The apparatus according to any one of the preceding Claims, wherein one or more pairs of lower grip rollers (44b'-44m', 46a', 46b') for pinching the lower edge portion of the band-shaped flexible substrate (1) in terms of the vertical direction are provided between the plurality of film forming chambers (42a-42m).

6. The apparatus according to Claim 5, wherein the one or more pairs of lower grip rollers (44b'-44m', 46a', 46b') are arranged between each pair of adjacent film forming chambers (42a-42m).

7. The apparatus according to Claim 5 or 6, wherein two or more pairs of the lower grip rollers (44b'-44m', 46a', 46b') are installed between the pair of adjacent forming chambers (42a-42m) positioned closest to the center of the arrangement of film forming chambers.

8. The apparatus according to any one of Claims 5 to 7, wherein the one or more pairs of lower grip rollers (44b'-44m', 46a', 46b') are installed in such a manner that the direction of rotation of the respective rollers is inclined obliquely downward with respect to the direction in which the band-shaped flexible substrate (1) is conveyed.

## Patentansprüche

1. Vorrichtung zur Herstellung eines dünnfilmlaminierten Elements durch Laminieren mehrerer Dünnfilme auf die Oberfläche eines bandförmigen elastischen Substrats, mit:
einer Substratfördervorrichtung (10, 20, 50, 60, 70) zum Fördern des bandförmigen elastischen Substrats (1) in horizontaler Richtung auf eine solche Weise, dass die breitenweise Richtung des bandförmigen elastischen Substrats (1) in vertikaler Richtung ausgerichtet ist;
mehreren filmbildenden Kammern (42a-42m), die der Reihe nach in der Richtung angeordnet sind, in welcher das bandförmige elastische Substrat (1) zum Bilden von Filmen auf der Oberfläche des bandförmigen elastischen Substrats (1) befördert wird; und
einem oder mehreren Paaren oberer Griffwalzen (44b-44m, 46a, 46b), die zwischen den mehreren filmbildenden Kammern (42a-42m) zum Einklemmen eines oberen Randbereichs des bandförmigen elastischen Substrats (1) angeordnet sind.

2. Vorrichtung nach Anspruch 1, wobei das eine oder die mehreren Paare oberer Greifwalzen (44b-44m, 46a, 46b) zwischen jedem Paar nebeneinander liegender bildender Kammern (42a-42m) eingebaut sind.

3. Vorrichtung nach Anspruch 1 oder 2, wobei zwei oder mehr Paare oberer Griffwalzen (44b-44m, 46a, 46b) zwischen dem Paar nebeneinander liegender bildender Kammern (42a-42m) eingebaut sind, das der Mitte der Anordnung filmbildender Kammern am nächsten positioniert ist.

4. Vorrichtung nach irgendeinem der vorhergehenden Ansprüche, wobei das eine oder die mehreren Paare oberer Griffwalzen (44b-44m, 46a, 46b) auf eine solche Weise eingebaut sind, dass die Drehrichtung der jeweiligen Walzen schräg nach oben in Bezug auf die Richtung geneigt ist, in welcher das bandförmige elastische Substrat (1) befördert wird.

5. Vorrichtung nach irgendeinem der vorhergehenden Ansprüche, wobei ein oder mehrere Paare unterer Griffwalzen (44b'-44m', 46a', 46b') zum Einklemmen des unteren Randbereichs des bandförmigen elastischen Substrats (1) hinsichtlich der vertikalen Richtung zwischen den mehreren filmbildenden Kammern (42a-42m) vorgesehen sind.

6. Vorrichtung nach Anspruch 5, wobei das eine oder die mehreren Paare unterer Griffwalzen (44b'-44m', 46a', 46b') zwischen jedem Paar nebeneinander liegender filmbildender Kammern (42a-42b) angeordnet sind.

7. Vorrichtung nach Anspruch 5 oder 6, wobei zwei oder mehr Paare der unteren Griffwalzen (44b'-44m', 46a', 46b') zwischen dem Paar nebeneinander liegender bildender Kammern (42a-42m) eingebaut sind, das der Mitte der Anordnung filmbildender Kammern am nächsten positioniert ist.

8. Vorrichtung nach irgendeinem der Ansprüche 5 bis 7, wobei das eine oder die mehreren Paare unterer Griffwalzen (44b'-44m', 46a', 46b') auf eine solche Weise eingebaut sind, dass die Drehrichtung der jeweiligen Walzen schräg nach unten in Bezug auf die Richtung geneigt ist, in welcher das bandförmige elastische Substrat (1) befördert wird.

## Revendications

1. Appareil pour fabriquer un élément stratifié à films minces par stratification d'une pluralité de films minces sur la surface d'un substrat souple en forme de bande, comprenant :
- un dispositif de transport de substrat (10, 20, 50, 60, 70) pour transporter le substrat souple en forme de bande (1) dans la direction horizontale de telle manière que la direction de la largeur du substrat souple en forme de bande (1) est orientée dans la direction verticale ;
- une pluralité de chambres de formation de films (42a-42m) agencées successivement le long de la direction dans laquelle le substrat souple en forme de bande (1) est transporté pour former des films sur la surface du substrat souple en forme de bande (1) ; et
- une ou plusieurs paires de rouleaux de prise supérieurs (44b-44m, 46a, 46b) agencées entre la pluralité de chambres de formation de films (42a-42m) pour pincer une partie de bord supérieur du substrat souple en forme de bande (1).

2. Appareil selon la revendication 1, dans lequel la ou les paires de rouleaux de prise supérieurs (44b-44m, 46a, 46b) sont installées entre chaque paire de chambres de formation de films adjacentes (42a-42m).

3. Appareil selon l'une des revendications 1 ou 2, dans lequel deux ou plusieurs paires de rouleaux de prise supérieurs (44b-44m, 46a, 46b) sont installées entre la paire de chambres de formation de films adjacentes (42a-42m) positionnée le plus près du centre de l'agencement de chambres de formation de films.

4. Appareil selon l'une quelconque des revendications précédentes, dans lequel la ou les paires de rouleaux de prise supérieurs (44b-44m, 46a, 46b) sont installées de telle manière que la direction de rotation des rouleaux respectifs est inclinée obliquement vers le haut par rapport à la direction dans laquelle le substrat souple en forme de bande (1) est transporté.

5. Appareil selon l'une quelconque des revendications précédentes, dans lequel une ou plusieurs paires de rouleaux de prise inférieurs (44b'-44m', 46a', 46b') pour pincer la partie de bord inférieur du substrat souple en forme de bande (1), en termes de direction verticale, sont agencées entre la pluralité de chambres de formation de films (42a-42m).

6. Appareil selon la revendication 5, dans lequel la ou les paires de rouleaux de prise inférieurs (44b'-44m', 46a', 46b') sont agencées entre chaque paire de chambres de formation de films adjacentes (42a-42m).

7. Appareil selon l'une des revendications 5 ou 6, dans lequel deux ou plusieurs paires des rouleaux de prise inférieurs (44b'-44m', 46a', 46b') sont installées entre la paire de chambres de formation de films adjacentes (42a-42m) positionnée le plus près du centre de l'agencement de chambres de formation de films.

8. Appareil selon l'une quelconque des revendications 5 à 7, dans lequel la ou les paires de rouleaux de prise inférieurs (44b'-44m', 46a', 46b') sont installées de telle manière que la direction de rotation des rouleaux respectifs est inclinée obliquement vers le bas par rapport à la direction dans laquelle le substrat souple en forme de bande (1) est transporté.
